(19) Europäisches Patentamt

European Patent Office

Office européen des brevets

(11) **EP 0 900 398 B1**

(12) **EUROPEAN PATENT SPECIFICATION**

(45) Date of publication and mention
of the grant of the patent:
**18.02.2004 Bulletin 2004/08**

(51) Int Cl.⁷: **G02B 6/16**

(86) International application number:
**PCT/US1997/008144**

(21) Application number: **97936931.1**

(22) Date of filing: **09.05.1997**

(87) International publication number:
**WO 1997/044692 (27.11.1997 Gazette 1997/51)**

(54) **FABRICATION OF SMALL-SCALE COILS AND BANDS AS PHOTOMASKS ON OPTICAL FIBERS FOR GENERATION OF IN-FIBER GRATINGS, ELECTROMAGNETS AS MICRO-NMR COILS, MICROTRANSFORMERS, AND INTRA-VASCULAR STENTS**

HERSTELLUNG VON KLEINEN SPULEN UND BÄNDERN ALS PHOTOMASKE AUF OPTISCHEN FAERN ZUR ERZEUGUNG VON FASERGEMITTERN, ELEKTROMAGNETEN ALS MIKRO-NMR-SPULEN, MIKROTRANSFORMATOREN UND INTRAVSKULÄREN STANTS

FABRICATION DE BOBINES ET DE BANDES A ECHELLE REDUITE UTILISABLES COMME MASQUES PHOTOGRAPHIQUES SUR DES FIBRES OPTIQUES POUR LA PRODUCTION DE RESEAUX DE FIBRES, D'ELECTRO-AIMANTS SERVANT DE BOBINES POUR MICRO-RMN, DE MICRO-TRANSFORMATEURS ET D'EXTENSEURS INTRAVASCULAIRES

(84) Designated Contracting States:
**AT BE CH DE DK ES FI FR GB GR IE IT LI LU MC NL PT SE**

(30) Priority: **09.05.1996 US 19065 P**
**22.07.1996 US 681235**

(43) Date of publication of application:
**10.03.1999 Bulletin 1999/10**

(73) Proprietor: **PRESIDENT AND FELLOWS OF HARVARD COLLEGE**
**Cambridge, Massachusetts 02138-5701 (US)**

(72) Inventors:
• **ROGERS, John, A.**
**Cambridge, MA 02138 (US)**
• **JACKMAN, Rebecca, J.**
**Boston, MA 02114 (US)**
• **WHITESIDES, George, M.**
**Newton, MA 02158 (US)**

(74) Representative: **Killin, Stephen James et al**
**Venner, Shipley & Co.,**
**20 Little Britain**
**London EC1A 7DH (GB)**

(56) References cited:
**EP-A- 0 140 259**  **EP-A- 0 441 693**
**US-A- 5 112 438**  **US-A- 5 421 955**

• **KASHYAP R ET AL: "UV WRITTEN REFLECTION GRATING STRUCTURES IN PHOTOSENSITIVE OPTICAL FIBRES USING PHASESHIFTED PHASE MASKS" ELECTRONICS LETTERS, vol. 30, no. 23, 10 November 1994, page 1977/1978 XP000495746**
• **HILL K O ET AL: "BIREFRINGENT PHOTOSENSITIVITY IN MONOMODE OPTICAL FIBRE: APPLICATION TO EXTERNAL WRITING OF ROCKING FILTERS" ELECTRONICS LETTERS, vol. 27, no. 17, 15 August 1991, pages 1548-1550, XP000259837**
• **"PLATED METAL MASK FOR PRECISE EXCIMER LASER ABLATION OF GLASSES" IBM TECHNICAL DISCLOSURE BULLETIN, vol. 34, no. 6, November 1991, page 253/254 XP000228432**
• **PATENT ABSTRACTS OF JAPAN vol. 016, no. 288 (E-1223), 25 June 1992 & JP 04 073917 A (MITSUBISHI ELECTRIC CORP), 9 March 1992,**

## Description

The invention relates generally to the fabrication of small-scale patterned cylindrical structures and more particularly to the fabrication of coils and cylindrical grid structures on cylindrical substrates for use as microtransformers, microelectromagnets, and intravascular stents.

A field that involves fabrication in connection with small-scale articles such as cylindrical articles is the field of microelectronics. Miniaturization of electrical components has created a need for microinductors and microtransformers. The large number of turns per unit length required for these structures makes fabrication of miniaturized inductors and transformers challenging. While several different methods for the generation of planar microtransformers using conventional silicon processing techniques have been developed, conventional techniques such as photolithographic processes can form high resolution patterns on planar substrates but lack the depth of focus to pattern non-planar substrates. Three-dimensional structures typically are obtainable only through stepwise addition or removal of planes or strips of material, a labor and material-intensive process, that limits the possible geometries.

Kawahito, et al., in an article entitled "A Fluxgate Magnetic Sensor with Micro-Solenoids and Electroplated Permalloy Cores", *Sensors and Actuators A,* 43, 128-134 (1994),
describe a fluxgate magnetic sensor produced via silicon micro-technology. For a rod-core sensor, a relatively complicated fabrication process is involved including groove formation, round etching and oxidation, electron-beam lithography, evaporation and lift-off, $SiO_2$ sputtering and Cu electron-beam evaporation, Cu patterning and resist patterning, NiFe selective electroplating, Cu film removal and planarization, and through-hole and Al patterning.

In an article entitled "High-Resolution Microcoil $^1$H-NMR For Mass-Limited Nanoliter-Volume Samples", *Science,* 270, 1967-1970 (December 22, 1995), Olson, et al., described a polyimide-coated fused-silica capillary surrounded by a microcoil for use in proton micro-NMR spectroscopy. The microcoil was made from 50 micron diameter wire, and was wound about the cylindrical substrate. Adhesive was applied to adhere the coil to the substrate. Coil fabrication was monitored with a dissecting stereomicroscope.

While fabrication of three-dimensional microelectronic devices has yielded some successes, known techniques for such fabrication are relatively complicated.

Stents are tiny scaffolds that can be introduced into a blood vessel, typically a coronary artery after balloon angioplasty, and expanded in the vessel to hold the vessel open. Because stents are cylindrical structures of metal with feature sizes in the range of 50-100 microns, they can be difficult to produce using conventional methods and, as a result, costs are high. U.S. Patent No. 4,655,771 (Wallsten) describes a stent for transluminal implantation. The device can be fabricated by weaving, and points at which filaments defining the stent cross can be welded together.

U.S. Patent No. 5,421,955 is directed to an expandable stent. These stents can be formed by coating a stainless steel hydrotubing with a material resistant to chemical etching. Exposed portions of the underlying tubing are removed by chemical etching, leaving untouched portions of the metallic tubing that ultimately form the stent.

It is an object of the invention to provide a simple, relatively inexpensive technique for fabricating small-scale, three-dimensional, preferably cylindrical metal structures such as microtransformers, microinductors, and stents.

The present invention provides a number of small-scale devices that can be used as microelectronic and analytical elements. In one aspect the invention provides an article that comprises an electrically-conductive coil having a layer of turns of at least 30 turns per mm. In one embodiment, the coil is disposed on a cylindrical surface of a cylindrical article, such as a tube which can be constructed and arranged to receive a sample for NMR analysis and to be positioned in NMR analysis equipment.

The invention also provides an article having an exterior surface and an interior receptacle and an electrically-conductive material deposited on at least a portion of the exterior surface. The article can be cylindrical, and can be constructed and arranged to receive a sample of NMR analysis and to be positioned in NMR analysis equipment.

According to another embodiment the invention provides a device including a cylindrical portion having a surface and an electrically-conductive material deposited on the surface defining a pattern including at least one continuous, isolated section that encircles the cylindrical portion. In one embodiment, the device includes material, such as ferromagnetic material, positioned axially within the cylindrical portion.

According to another aspect, the invention provides methods for fabrication of small-scale articles. In one embodiment, a method of the invention involves chemically depositing, on an exterior surface of a receptacle, or an electrically-conductive material in a pattern. In another embodiment, the invention provides a method involving forming a pattern of a self-assembled monolayer on an exterior surface of a cylindrical article. In either case the pattern includes at least one continuous, isolated portion that encircles the cylinder. The article can be contacted with an etchant that reacts chemically with the article thereby degrading a portion of the article in a pattern dictated by the pattern of the self-assembled monolayer.

According to another embodiment, the invention provides a method that involves forming a pattern of a molecular species on an exterior surface of a cylindrical article. The molecular species can be a self-assembled monolayer or a catalyst, according to preferred embodiments, and the pattern includes one continuous, isolated portion that encircles the cylinder. The surface of the article then is plated with a plating reagent in a pattern dictated by the molecular species.

The invention also provides a method that involves forming, on an exterior surface of a cylindrical substrate, a discontinuous, interconnected, cylindrical, metallic article. The metallic article then is removed from the substrate. The article can be formed on the substrate by providing a layer of metal on the exterior surface and removing one portion of the layer of metal while allowing a second, discontinuous, interconnected portion of the metal layer to remain on the substrate and to define the metallic article. The first portion can be removed by chemical etching by, for example, protecting the second portion of the metal with an etchant resist made from a resist precursor transferred from an application surface of an applicator. The etchant resist precursor can be a self-assembled monolayer, optionally including an etchant resist deposited thereon after formation of a patterned self-assembled monolayer.

Alternatively, the etchant resist can be a metal, the etchant resist formed by depositing an activating agent capable of promoting deposition of a metal on the second portion of the layer of metal, followed by deposition of metal at the second portion.

According to another embodiment, the method of forming a discontinuous, interconnected, cylindrical metallic article on a substrate and removing the article from the substrate involves providing a metal layer on the substrate, removing a first portion of the metal layer while allowing a second, discontinuous, interconnected, portion to remain on the substrate, and depositing a metal that defines the discontinous, interconnected, metallic article on the second portion of the metal layer. In one embodiment, the second portion of the metal layer is a catalyst, and the depositing step involves carrying out electroless metal deposition at the second portion of the metal layer. In another embodiment, the depositing step involves electrochemically depositing a metal that defines the metallic article on the second portion of the metal layer. The metal layer and the electrochemically-deposited metal can be the same. The first portion of the layer of metal deposited on the substrate can be removed via the above-described techniques.

In one embodiment, the article removed from the substrate is designed for use as a stent.

The invention also provides articles and devices formed according to the above-described methods, and provides methods of use of these and others of the above-described articles.

Fig. 5 illustrates schematically a technique for fabrication of a metallic coil on the exterior surface of a hollow, cylindrical article, formation of multi-layered coils, and a creation of a microinductor or microtransducer;

Fig. 6 illustrates schematically a technique for printing coils on an exterior surface of a cylindrical article;

Fig. 7 illustrates schematically creation of a discontinuous, interconnected, cylindrical, metallic article such as a stent on the exterior surface of a cylindrical article;

Fig. 8 illustrates schematically an alternate pattern for the article illustrated in Fig. 7; and

Fig. 9 is an NMR spectrum of ethylbenzene obtained in a micro-NMR sample tube fabricated in accordance with the invention.

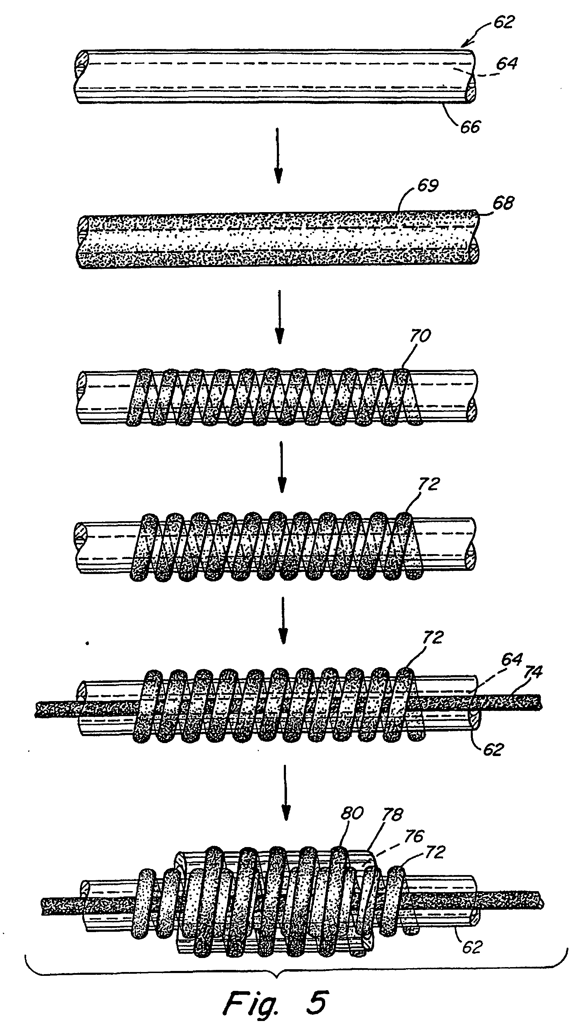

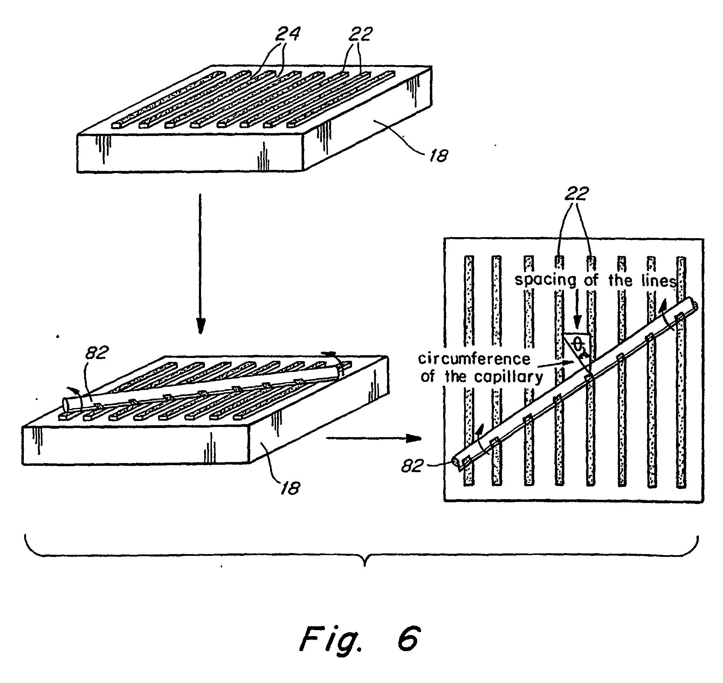

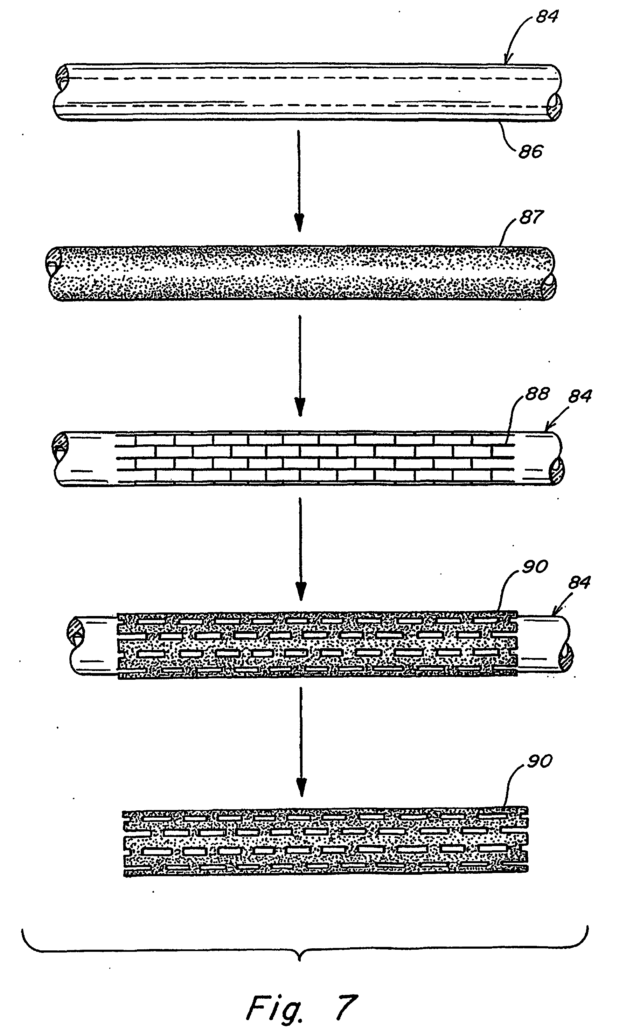

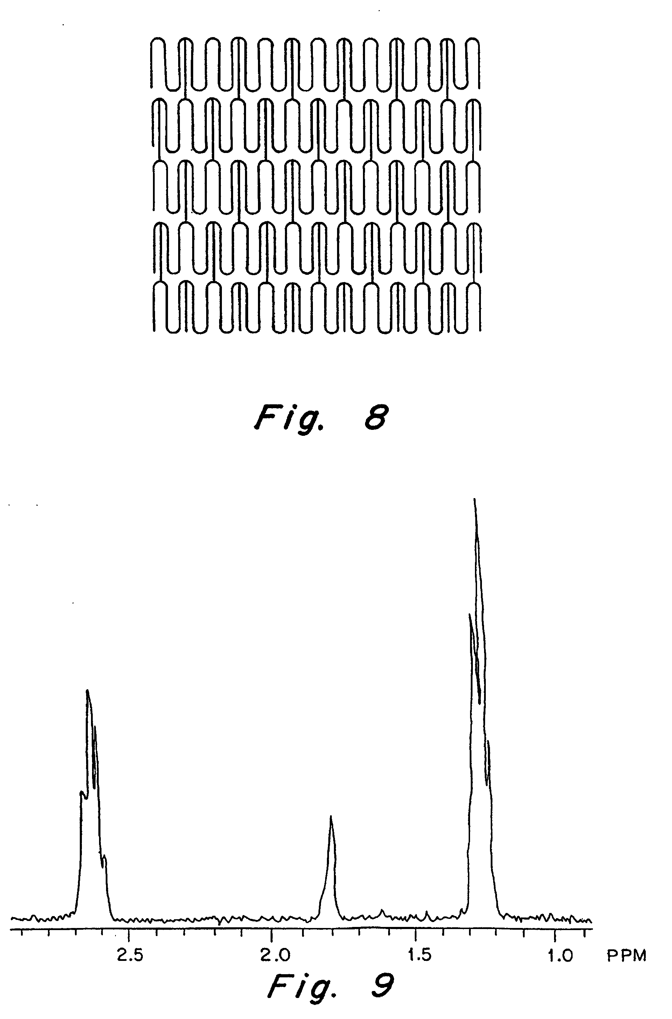

The invention provides techniques for fabricating small-scale metallic structures such as coils and stents, optionally on the exterior surface of cylindrical articles. Referring to Fig. 5, an embodiment of the technique is illustrated schematically. A cylindrical article 62 (including, as illustrated, a hollow, central passageway 64) has an exterior surface 66 that is coated with a thin layer 68 of metal having an exterior surface 69. A pattern of a molecular species is formed on exterior surface 69, the pattern being the same as, or complementary to, a pattern 70 of metal layer 68 desirably retained on external surface 66 of article 62. The molecular species can be a self-assembled monolayer in coil pattern 70, which is resistant to an etchant that can remove metal 68. Exposure of this arrangement to the etchant removes metal layer 68 except at coil pattern 70, coil pattern 70 being protected by the self-assembled monolayer. Alternatively, the molecular species can be a catalyst that promotes deposition of a metal from an electroless plating bath, and a plated metal protecting species, in the pattern of coil 70, applied to layer 68 in this manner. Subsequent etching can result in coil 70.

In another arrangement, a molecular species can be patterned in a pattern complementary to coil 70, which molecular species directs an etchant resist to form a pattern that covers coil pattern 70. In this case, the molecular species would be selected to be incompatible with a precursor of an etchant resist, where the precursor is more compatible with metal 68. Following formation of a resist in a pattern of coil 70 (and optional removal of the directing molecular species if the directing molecular species would be somewhat resistant to the etch), the system can be exposed to an etch removing portions of metal layer 68 other than portions in a coil pattern 70.

Described are techniques for establishing a thin layer of metal 68 in a coil pattern 70 on the exterior surface of a cylindrical article 62. Subsequently, metal is deposited on coil pattern 70 to define a final coil structure 72. The metal can be deposited via electroless deposition where metal pattern 70 is a catalyst, or by addressing metal coil 70 electrically and carrying out electrochemical deposition. The metal defined in coil pattern 70 and metal that is deposited thereon to define coil 72 can be the same, or different, depending upon the fabrication technique.

Metal coil 72 on substrate 62 can serve a variety of purposes. According to one, passageway 64 receives an NMR sample and coil 72 serves as an electromagnet for NMR analysis. According to another, coil 72 is removed from substrate 62 by, for example, dissolving the substrate, and the coil is used as an NMR coil or other device. According to another embodiment, as illustrated in Fig. 5, coil 72 remains on substrate 62 and ferromagnetic material 74 is passed through central cavity 64 of substrate 62. Ferromagnetic material 74 passing through coil 72 defines a concentrically wound, cylindrical microtransformer.

In one embodiment, a multi-layer coiled arrangement is produced. As used herein, the term "layer" of a coil means a coil that includes a metallic conductor in a coiled pattern where each portion of the conductor is in alignment, axially, with other portions of the coil. That is, a "layer" of a coil does not include conductor defining the coil on top of other conductor, or conductor sections staggered so that more "windings" can be provided per unit axial length of the coil. Each winding of the coil need not have the same radius of curvature, as substrate 62 could taper, and a coil formed about substrate 62 when it is tapered would still involve a single "layer" of coil. The invention provides a coil having a layer of turns of at least 30 turns per mm, preferably at least about 50 turns per mm, and more preferably at least about 100 turns per mm.

In Fig. 5, a second "layer" of coil is provided by inserting coil 72 and substrate 62 within a receptacle (central hollow portion) 76 of a cylindrical substrate 78 having deposited thereon a second coil 80. A concentric, cylindrical microtransformer results. Both inner coil 72 and outer coil 80 can be contacted electrically.

Referring now to Fig. 6, a technique for patterning a coil on an exterior surface of a cylindrical article is illustrated schematically. An article 18 (as described above with reference to Fig. 2) is provided. For positioning, an arrangement as described above with reference to Fig. 3 can be used. A cylindrical article 82 is placed on the top surfaces of protrusions 22 at an angle that is not perpendicular to the protrusions, and rolled across the protrusions. Where the article 18 consists of an array of parallel protrusions, the relative orientation of the article and cylindrical article 82 can be adjusted so that when the cylindrical article 82 is rolled across the surface of the article 18 a continuous coil is printed on the exterior surface of cylindrical article 82. As in other embodiments, the material printed on the exterior surface of article 82 thereby can prevent removal of material from the surface or initiate deposition of the material at the surface. To select an appropriate orientation of cylindrical article 82 and parallel protrusions 22, the following equation can be used:

$$\sin\theta = \frac{nd}{2\pi r}$$

where θ is the angle made between linear protrusions 22 and a line perpendicular to the axis of article 82, d is the dimension of the spacing of the protrusions, r is the radius of cylindrical article 82, and n is an integer. Where n=1, a single helical structure results. Where n=2, a double helical structure results, etc.

Referring now to Fig. 7, a technique for fabricating a stent is illustrated. The technique involves providing a cylindrical article 84 having an exterior surface 86, depositing a thin layer of metal on surface 87, and removing a first portion of the layer of metal from the substrate while allowing a second, discontinuous, interconnected portion of the metal layer 88 to remain on the substrate. As used herein, the phrase "discontinuous, interconnected portion" is meant to define a portion of a layer of metal that includes voids, but is interconnected in that electrical contact with any portion of the portion provides electrical contact with the entire portion. A coil is a discontinuous, interconnected portion of a layer of metal.

Removal of portions of metal layer 87 (portions other than the second portion 88 that is allowed to remain) can be carried out by etching the first portions of the metal layer. This can be done by protecting second portion 88 by microcontact printing (U.S. Patent No. 5,512,131) a pattern of a protecting species corresponding to portion 88 on layer 87. This can be accomplished by providing an article (not shown) similar to article 18 but including a protrusion pattern corresponding to the pattern of portion 88 of the metal layer, coating the protrusions with a precursor of an etchant resist, and forming the resist at portions 88 by rolling article 84 across the article, thereby transferring to portion 88 the precursor of the etchant resist. The precursor of the etchant resist can be a self-assembled monolayer-forming species, thus the etchant resist at portions 88 can be a self-assembled monolayer. Alternatively, a self-assembled monolayer can be formed at portion 88, followed by exposure of the arrangement to an etchant resist that is chemically compatible with the self-assembled monolayer at portion 88. For example, where the self-assembled monolayer at portion 88 terminates in a hydrophobic functionality, a hydrophobic etchant resist will readily be applied to the self-assembled monolayer and serve as an etchant resist. For example, where the self-assembled monolayer at portion 88 is one such as $-Cl_3SiR$ or $-(EtO)_3SiR(R=-(CH_2)_3NH_2, -(CH_2)_3SH,-(CH_2)_3BR, -(CH_2)NCO,-(CH_2)_2(CF_2)_5CF_3,$ or $-(CH_2)_{15}(CH=CH_2)$ (with subsequent treatment of the patterned self-assembled monolayers containing vinyl-terminated regions with an aqueous solution of $KMnO_4$ and $KiO_4$ to convert the olefins to carboxylic acids), and application of this self-assembled monolayer to the first portion of the surface 86 (the portion complementary to portion 88), followed by exposure to liquid polyurethane and curing, cured polyurethane as an etchant resist at regions 88 results. Removal of this self-assembled monolayer during, or prior to, exposure of the surface to etchant results in removal of the first portions of layer 87 complementary to remaining portion 88.

Subsequently, a layer of metal that defines the stent is deposited on the patterned, second portion 88. A discontinuous, interconnected, cylindrical, metallic article 90, having a thickness suitable for removal from substrate 84 to serve as a free-standing article, results. Deposition of metal at second portion pattern 88 can be carried out according to a variety of methods. According to one, portion 88 is a catalyst and the article is subjected to electroless deposition. According to another, electrical connection is made with pattern 88 and metal is electrochemically deposited at portion 88. Both techniques are well-known to those with ordinary skill in the art.

Subsequently, article 90 is removed from substrate 84 by, for example, dissolving substrate 84. A resulting free-standing article 90 results. Where article 90 serves as a stent, it can be disposed about an inflatable balloon of a catheter, positioned in a desired region of a vessel (typically a coronary artery) and expanded against the vessel wall by inflation of the balloon. The discontinuous pattern of article 90 can be expanded since portions of the pattern that run axially will, when the stent is expanded, be drawn into a zig-zag pattern (this can be visualized more easily with reference to structure 88).

Referring to Fig. 8, an alternate pattern for patterned metal portion 88 is illustrated. This pattern can be arranged about the cylindrical article with the axis of the article lying in any orientation relative to the pattern of Fig. 8, and the resulting stent is easily expandable.

In each of the above embodiments, techniques for creation of one arrangement can be used for creation of any other arrangement. The invention lies in the technique of printing, on a surface of an article, a precursor that dictates a pattern of deposition on the article, etching in the article, or a combination for creation of a variety of useful devices. The pattern can be formed on or in a cylindrical article and, according to one embodiment, involves a pattern having at least one continuous, isolated portion that encircles the cylinder. As used herein, "continuous, isolated portion that encircles the cylinder" is meant to define an arcuate portion that encircles the cylinder at least once, for example, as defining a cylindrical band or one period of a coil, and is isolated in that the portion circling the article does not contact other portions except where it contacts itself as in a band.

The function and advantage of these and other embodiments of the present invention will be more fully understood from the examples below. The following examples are intended to illustrate the benefits of the present invention, but do not exemplify the full scope of the invention.

Example 1: Fabrication of Microcoil

Polyimide-coated capillaries were obtained from Polymicro Technologies, Inc. (Phoenix, Arizona). The polyimide coating was burned off using a resistively-heated filament. The outer diameter of the stripped fiber was 134.5 +/- 0.5 microns, and the inner diameter was 95.6 +/- 1.5 microns. The stripped capillaries were coated with titanium (about 15-30 Angstroms) and silver (about 300-500 Angstroms) using an electron beam evaporator. Mechanical stages were used to rotate the capillaries about two orthogonal axes during deposition.

Lines of a self-assembled monolayer formed of hexadecanethiol were printed on the outside of the capillaries using an arrangement as illustrated in Fig. 6. The self-assembled monolayer was printed in a pattern complementary to that of metal pattern 70 as illustrated in Fig. 5. The hexadecanethiol-printed capillaries were inserted into a ferri/ferrocyanide bath to remove silver not protected by the hexadecanethiol according to pattern 70 as illustrated in Fig. 5. Etching times on the order of 20 seconds were sufficient. This resulted in silver spirals 70 of a few hundred Angstroms thickness on glass capillaries coated with titanium a few tens of Angstroms thick. The samples were exposed 1% hydrofluoric acid for ten seconds to remove the exposed titanium.

A thin, gold wire was attached to one end of the silver-titanium spiral 70 using silver paint. Gold then was electroplated onto metallic pattern 70 by adjusting the current density to about 4mA/cm$^2$ and plating for several minutes. The plating technique resulted in spirals 72 made of gold, approximately 1-3 microns thick, on top of silver on top of titanium adhered to the outside of glass capillary 62.

The spiral 72 can be used as an electromagnet in, for example, an NMR arrangement in which an NMR sample is passed through the central portion 64 of the capillary 62. Coils 72 having a lateral dimension (dimension of a portion of the coil, in a direction axially, of 150, 50 and 20 microns) coils of length were produced.

Example 2: NMR Microcoil

A micro-NMR sample tube was fabricated. A silver-titanium spiral 70 of 1 turn per 100 microns length, 17 turns in length was formed on the outside of a stripped capillary as described in Example 1. Subsequently, copper was plated on the silver-titanium coil.

Neat ethylbenzene (including a small amount of water contaminant) was introduced into the capillary. NMR analysis was carried out as described in Olson, et al., *Science,* 270, 1967-1970 (December 22, 1995). The sample, coil, and tube were immersed in fluorinert™ FC-43 and placed in a General Electric GN-300WB 300 MHz sperometer, and an NMR spectrum obtained.W™ The spectrum appears in Fig. 9.

Example 3: Evaluation of Electromagnet

The arrangement described in connection with Example 1 was provided. Ferromagnetic wire (80% Ni, 15% Fe, 4.4% Mo, 6.6% other; diameter of 80 +/- 2 microns) was inserted into the core of the capillary (opening 64). The wire is sold under the mark MONIFE 479 from California Fine Wire (Grover Beach, California). The outer coil was contacted electrically. The connections were made with a test fixture of an LCR meter (Hewlett-Packard model 4284 A with internal DC bias, option 001) and Test Fixture 16334 A SMD. With this meter, inductance and resistance were determined as a function of frequency, magnitude of current used for the test, and magnitude of a constant bias applied during the test period.

A second arrangement involved a second coil spaced from the first coil. Electrical connection was made to each coil. Using two coils around adjacent regions of the same capillary, qualitative measurement of magnetic field induced by an alternating current passing through one of the coils was made by measuring the induced voltage in the other coil. For a given number of turns per inch, the inductance was a linear function of the length of the coil, and inductance per unit length was a quadratic function of the number of turns per unit length. The resulting electromagnet can be treated as an ideal solenoid, and the saturation point of the core material is the only limiting factor in the achievable magnetic field.

Example 4: Creation of Microtransformer

A structure including an inner coil, an outer coil, and a central wire was fabricated as described above in connection with Examples 1 and 3 and as illustrated in Fig. 5.

The specific dimensions were inner coil: length = 14.5 mm, winding = $2 \times 10^4$ turns/m and, for the outer coil: length = 3.1 mm and $1 \times 10^4$ turns/m. Inductance and resistance of the inner and outer coils, at 10mA applied current in the frequency range of from 1kHz to 1MHz, was measured. The inductance and resistance of the inner and outer coils connected in series with polarities aligned and opposed, at 10mA applied current, in the frequency range of 1kHz to 1MHz, was measured. The coupling efficiency in the frequency range from 1kHz to 1MHz was calculated.

The microtransformer had efficient coupling (coupling efficiency greater than 0.9) of its primary and secondary coils at frequencies less than 20 kHz.

**Claims**

1. A method comprising:

    forming a pattern (70) on an exterior surface (69) of a cylindrical article (68), the pattern (70) including at least one continuous, isolated portion that encircles the cylinder (68); and contacting the article (68) with an etchant that reacts chemically with the article (68) thereby degrading a portion of the article (68) in a pattern dictated by the pattern (70) of the surface (69) of the article (68), **characterised in that** the pattern (70) on the surface (69) of the article (68) is formed of a self-assembled monolayer.

2. A method as in claim 1, wherein the self-assembled monolayer is a resist to the etchant, and the etchant reacts chemically with the article (68) at portions other than portions at which the self-assembled monolayer is formed.

3. A method as in claim 1, wherein the cylindrical article (68) contains a central passageway (64).

4. A method as in claim 3, wherein the central passageway (64) is constructed and arranged to receive an NMR sample and the article (72) is constructed and arranged for positioning in NMR analysis equipment.

5. A method as in claim 3, wherein the central passageway (64) contains a ferromagnetic material (74).

6. A method as in claim 1, wherein the exterior surface (69) is a surface of metal (68).

7. A method as in claim 6, wherein the article (68) comprises a cylindrical substrate (62) having an exterior surface (66) carrying a layer of metal (68), the method involving contacting the article (68) with an etchant that reacts chemically with the metal (68) thereby degrading a portion of the metal (68) in a pattern (70).

8. A method as in claim 7, further comprising removing the self-assembled monolayer and plating a second metal on the metal (68) remaining on the substrate (62).

**Patentansprüche**

1. Methode umfassend:

    das Bilden eines Bilds (70) auf einer Außenfläche (69) eines zylindrischen Artikels (68), wobei das Bild (70) mindestens einen kontinuierlichen, isolierten Teil einschließt, der den Zylinder (68) umschließt, und das Kontaktieren des Artikels (68) mit einem Ätzmittel, das chemisch mit dem Artikel (68) reagiert, wobei ein Teil des Artikels (68) in Form eines Bilds abgebaut wird, das vom Bild (70) auf der Oberfläche (69) des Artikels (68) bestimmt ist, **dadurch gekennzeichnet, dass** das Bild (70) an der Oberfläche (69) des Artikels (68) aus einer sich von selbst einbauenden Einzelschicht gebildet ist.

**2.** Methode nach Anspruch 1, wobei die sich von selbst einbauende Einzelschicht einen Photolack für das Ätzmittel darstellt und das Ätzmittel chemisch mit dem Artikel (68) an Teilen reagiert, bei denen es sich nicht um Teile handelt, bei denen die sich von selbst einbauende Einzelschicht gebildet wird.

**3.** Methode nach Anspruch 1, wobei der zylindrische Artikel (68) einen zentralen Durchgang (64) enthält.

**4.** Methode nach Anspruch 3, wobei der zentrale Durchgang (64) so konstruiert und angeordnet ist, dass er eine NMR-Probe aufnimmt und der Artikel (72) für das Positionieren in eine NMR-Analysevorrichtung konstruiert und angeordnet ist.

**5.** Methode nach Anspruch 3, wobei der zentrale Durchgang (64) einen ferromagnetischen Werkstoff (74) enthält.

**6.** Methode nach Anspruch 1, wobei die Außenfläche (69) eine aus Metall bestehende Fläche (68) ist.

**7.** Methode nach Anspruch 6, wobei der Artikel (68) ein zylindrisches Substrat (62) mit einer Außenfläche (66) umfasst, die eine Schicht aus Metall (68) trägt, wobei die Methode das Kontaktieren des Artikels (68) mit einem Ätzmittel umfasst, das chemisch mit dem Metall (68) reagiert, wobei ein Teil des Metalls (68) in Form eines Bilds (70) abgebaut wird.

**8.** Methode nach Anspruch 7, die des Weiteren das Entfernen der sich von selbst einbauenden Einzelschicht und das Plattieren eines zweiten Metalls auf das auf dem Substrat (62) verbleibende Metall (68) umfasst.

**Revendications**

**1.** Procédé comprenant :

la formation d'un motif (70) sur une surface extérieure (69) d'un article cylindrique (68), le motif (70) incluant au moins une portion continue isolée qui encercle le cylindre (68) ; et
la mise en contact de l'article (68) avec un agent de mordançage qui réagit par voie chimique avec l'article (68), en dégradant ainsi une portion de l'article (68) dans un motif dicté par le motif (70) de la surface (69) de l'article (68), **caractérisé en ce que** le motif (70) sur la surface (69) de l'article (68) est formé d'une mono couche auto-assemblée.

**2.** Procédé selon la revendication 1, dans lequel la mono couche auto-assemblée est une résine sensible à l'agent de mordançage et dans lequel l'agent de mordançage réagit par voie chimique avec l'article (68) à des portions autres que les portions sur lesquelles la mono couche auto-assemblée est formée.

**3.** Procédé selon la revendication 1, dans lequel l'article cylindrique (68) contient un passage central (64).

**4.** Procédé selon la revendication 3, dans lequel le passage central (64) est construit et arrangé pour recevoir un échantillon RMN et dans lequel l'article (72) est construit et arrangé en vue du positionnement dans un équipement d'analyse RMN.

**5.** Procédé selon la revendication 3, dans lequel le passage central (64) contient un matériau ferromagnétique (74).

**6.** Procédé selon la revendication 1, dans lequel la surface extérieure (69) est une surface métallique (68).

**7.** Procédé selon la revendication 6, dans lequel l'article (68) comprend un substrat cylindrique (62), ayant une surface extérieure (66) portant une couche métallique (68), le procédé mettant en jeu la mise en contact de l'article (68) avec un agent de mordançage qui réagit par voie chimique avec le métal (68), en dégradant ainsi une portion du métal (68) pour former un motif (70).

**8.** Procédé selon la revendication 7, comprenant en outre l'enlèvement de la mono couche auto-assemblée et le dépôt d'une deuxième métal sur le métal (68) restant sur le substrat (62).

*Fig. 5*

Fig. 6

Fig. 7

Fig. 8

Fig. 9